# EUROPEAN PATENT APPLICATION

(11) **EP 3 713 112 A1**
(43) Date of publication of application: **23.09.2020**
(21) Application number: 19738797.0
(22) Date of filing: 10.01.2019
(51) Int. Cl.: H04B 17/15, H04B 17/10

(54) **RADIO FREQUENCY CABLE HEAD AND RADIO FREQUENCY PERFORMANCE TESTING DEVICE**

(30) Priority: 10.01.2018 CN 201820038010 U
(71) Applicant: ZTE Corporation, Shenzhen, Guangdong 518057 (CN)
(72) Inventor: LIU, Yuping, Shenzhen, Guangdong 518057 (CN)
(74) Representative: Baudler, Ron
(86) International application number: PCT/CN2019/071158
(87) International publication number: WO 2019/137433

(57) **Abstract**

Disclosed in the present application are a radio frequency cable head and a radio frequency performance testing device. The radio frequency cable head comprises a cable head housing and a first connection member and a second connection member both arranged inside the cable head housing. The first connection member is provided with an elastic piece connecting the second connection member, and the cable head housing is provided with a probe insertion hole. The radio frequency performance testing device includes the aforementioned radio frequency cable head.

## Description

### CROSS-REFERENCE TO RELATED APPLICATION

The present application claims the priority of Chinese Patent Application No. 201820038010.8, which is entitled "RADIO FREQUENCY CABLE HEAD AND RADIO FRQUENCY PERFORMANCE TESTING DEVICE" and filed on January 10, 2018, the entire contents of which are incorporated herein by reference.

### TECHNICAL FIELD

The present application relates to, but is not limited to, the technical field of communications, and in particular, relates to a radio frequency (RF) cable head and an RF performance testing device.

### BACKGROUD

In order to extend distance of a call, and improve call quality and voice clarity, a mobile communication terminal, such as a mobile phone or a tablet computer, is usually required to have certain transmission power. However, an increase in transmission power may cause a Specific Absorption Rate (SAR) to exceed a standard. Therefore, the terminal is generally designed in such a way that an antenna daughter board is disposed at an end of the mobile phone away from the earphone of the mobile phone, and is specifically coupled to a motherboard through an RF cable.

Under the condition that the RF cable is coupled, how to meet requirements of performing corresponding fault analysis, performance test and RF performance test needs to be considered. Under such condition, developers usually add a test socket between an RF cable connector and an antenna switch to meet the above requirements. If the above requirement of performing the RF performance test does not need to be considered, the developers may couple the antenna switch to the RF connector directly.

At present, motherboard signals are communicated to an antenna daughter board in a mobile terminal mainly by the following two connection ways.

First connection way, power amplifier - antenna switch - test socket - connector - RF cable - connector - antenna daughter board. The first connection way has the advantage that the RF performance test and the fault analysis can be directly carried out under the condition that the RF cable is connected due to the arrangement of the test socket, that is, the corresponding RF performance test can be directly carried out without disassembling the terminal, and it has the disadvantages that a relative large area of the motherboard is occupied and the cost is relative high due to the use of more connecting devices.

Second connection way, power amplifier - antenna switch - connector - RF cable - connector - antenna daughter board. The second connection way has the advantages of smaller occupied area of the motherboard and low cost due to the use of fewer connecting devices, and it has the disadvantage of relatively complicated operation for performing the corresponding performance test and fault analysis, because the RF cable needs to be removed from the terminal after starting the terminal.

### SUMMARY

In order to solve the above technical problems, the present application provides an RF cable head and an RF performance testing device, which allow performing a corresponding RF performance test under the condition that the number of connecting devices is reduced and the cable is kept connected. The test operation is simplified because there is no need to disassemble the terminal during the test process, and meanwhile, the occupied area of the motherboard and the overall cost of the terminal can be effectively reduced.

In order to solve the above technical problems, the present application provides an RF cable head, including a cable head housing, a first connector and a second connector, wherein both the first connector and the second connector are disposed inside the cable head housing, the first connector is connected with the second connector, and the cable head housing is provided with a probe hole through which a probe is inserted to disconnect the first connector from the second connector.

The RF cable head may further have a technical feature that the first connector is provided with a spring connected with the second connector.

The RF cable head may further have a technical feature that the probe hole faces the spring directly.

The RF cable head may further have a technical feature that an end of the first connector away from the second connector is provided with a pin or a jack, which is configured to be matched and connected with a jack or a pin of a board connector.

The RF cable head may further have a technical feature that an end of the second connector away from the first connector is provided with a pin or a jack, which is configured to be matched and connected with a jack or a pin of a subsequent circuit.

The RF cable head may further have a technical feature that the spring is connected to the second connector through a protrusion.

The RF cable head may further have a technical feature that the protrusion is disposed on the second connector or the spring.

The RF cable head may further have a technical feature that the cable head housing is an insulating housing.

In order to solve the above technical problems, the present application further provides an RF performance testing device, including the above RF cable head.

The RF performance testing device may further have a technical feature that the RF performance testing device further includes the probe which is inserted through the probe hole to disconnect the first connector from the second connector during a test process.

The above technical solutions of the present application produce the following beneficial effects.

As compared with the prior art, the RF cable head provided by the present application allows performing a corresponding RF performance test under the condition that the number of connecting devices is reduced and the cable is kept connected. In addition, the test operation is simplified because there is no need to disassemble the terminal during the test process, and meanwhile, the occupied area of the motherboard and the overall cost of the terminal can be effectively reduced.

The other technical features and advantages of the present application will be illustrated below in the Description, and may become partially obvious through the Description, or be understood by enabling the embodiments of present application. The objectives and the other advantages of the present application may be realized and attained with the structures particularly pointed out in the Description, Claims and Drawings.

### BRIEF DESCRIPTION OF THE DRAWINGS

The accompanying drawings are intended to provide further understanding of the technical solutions of the present application, and are incorporated in and constitute a part of the specification. The drawings, together with the embodiments of the present application, are intended to explain the technical solutions of the present application, but the technical solutions of the present application are not limited thereto. In the drawings,
Fig. 1 is a structural diagram illustrating Embodiment One of the present application; and
Fig. 2 is a schematic diagram illustrating application of Embodiment One of the present application.

### DETAILED DESCRIPTION

The embodiments of the present application are described in detail below with reference to the accompanying drawings. It should be noted that the embodiments and the technical features thereof in the present application may be arbitrarily combined with one another if no conflict is incurred.

### Embodiment One:

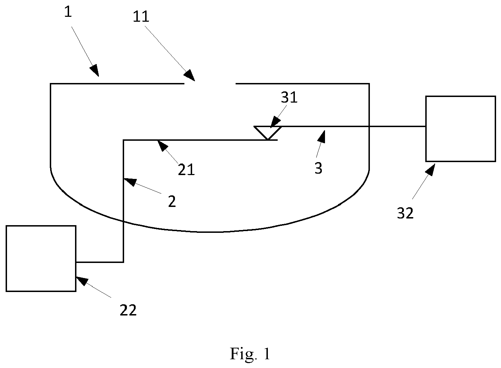

As shown in Fig. 1, Embodiment One provides an RF cable head mainly including a cable head housing 1, a first connector 2 and a second connector 3. Both the first connector 2 and the second connector 3 are disposed inside the cable head housing 1. The first connector 2 is connected with the second connector 3.

In practical application, the cable head housing 1 is provided with a probe hole 11 through which a probe is inserted to disconnect the first connector 2 from the second connector 3. The cable head housing 1 is preferably an insulating housing. When an RF performance test needs to be performed, the probe may be inserted into the cable head housing 1 through the probe hole 11, so that the probe may press the first connector 2 to disconnect the first connector 2 from the second connector 3, and the probe may be connected with the first connector 2 so as to perform the corresponding RF performance test.

In the embodiment, the first connector 2 is provided with a spring 21 connected with the second connector 3. The spring 21 is arranged in such a way that an elastic force of the spring 21 itself can ensure stable connection between the first connector 2 and the second connector 3, and the spring 21 can be bent under an external force applied by the probe to disconnect the first connector 2 from the second connector 3.

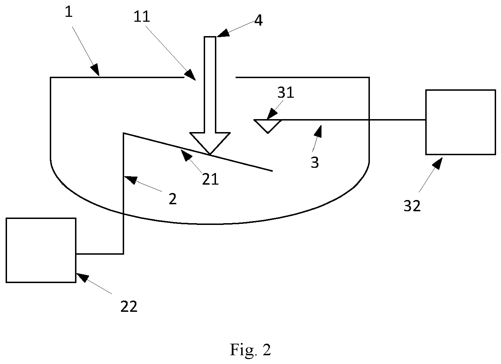

As shown in Fig. 2, when there is a need to carry out an RF performance test, a probe 4 may be inserted through the probe hole 11, and press the spring 21 of the first connector 2 to control the first connector 2 to be disconnected from the second connector 3. In this way, the probe 4 is connected with the first connector 2 through the spring 21, so that the corresponding RF performance test operation may be performed. Since the second connector 3 is disconnected from the first connector 2, an influence of a subsequent circuit 32 of the second connector 3 on the test result may be effectively avoided.

By adopting the above RF cable head, the corresponding test operation may be performed with no need to open the cable head housing 1 in the test process, which simplifies the test operation. In addition, the test operation does not need an RF test socket, which may effectively reduce corresponding connecting devices, thereby decreasing the occupied area of the motherboard and lowering overall cost effectively.

In the embodiment, an end of the first connector 2 away from the second connector 3 is matched and connected with a board connector 22.

In practical application, the board connector 22 is a motherboard connector, and the subsequent circuit 32 is a motherboard circuit. The first connector 2 is connected with the motherboard connector, and the second connector 3 is connected with the motherboard circuit. When there is a need to perform an RF performance test, the probe 4 is inserted through the probe hole 11 and press the spring 21 of the first connector 2 downwards to break a connection to the motherboard circuit connected with the second connector 3. In this way, the probe 4, the first connector 2 and the motherboard connector are in a connected state, so that the corresponding RF performance test operation may be performed.

It should be noted that the board connector 22 may be an antenna daughter board connector, or other similar connector, in which case a specific RF performance test operation is similar to the RF performance test operation in the case that the board connector 22 is a motherboard connector.

In the embodiment, the first connector 2 is connected with the board connector 22 by plugging.

In practical application, the end of the first connector 2 away from the second connector 3 is provided with a pin or a jack, and the board connector 22 is correspondingly provided with a jack or a pin, so that the first connector 2 may be easily connected with the board connector 22 by plugging.

In the embodiment, the spring 21 and the second connector 3 are connected with each other through a protrusion 31 which may be provided on the second connector 3 or the spring 21.

In the embodiment, the second connector 3 and the subsequent circuit 32 are connected with each other by plugging.

In practical application, an end of the second connector 3 may be made into a structure similar to that of the end of the first connector 2. That is, the end of the second connector 3 is provided with a pin or a jack, and the subsequent circuit 32 is correspondingly provided with a jack or a pin, so that the second connector 3 may be easily connected with the subsequent circuit 32 by plugging.

In the embodiment, the probe hole 11 may be a circular hole, or a rectangular hole, or a hole in another shape, as long as the probe may be easily inserted through the probe hole 11.

### Embodiment Two

Embodiment Two of the present application provides an RF performance testing device, which includes the RF cable head disclosed in Embodiment One, and further includes the probe which is inserted through the probe hole to disconnect the first connector from the second connector during a test process.

In practical application, the probe may be inserted through the probe hole and press the spring of the first connector, so that the spring is pressed to be bent and deformed to be disconnected from the second connector. In this way, the probe and the spring are in a connected state, so that a corresponding RF performance test operation may be performed, and the subsequent circuit and the probe are in a disconnected state, so that the influence of the subsequent circuit on the test result can be avoided.

In the description of the present application, the terms "dispose", "couple", "connect" and "fix" and the like should be interpreted in a broad sense, for example, "connect" may indicate a fixed connection, a detachable connection, or an integral connection, and also may indicate a direct connection, or an indirect connection through an intermediate medium. The specific meanings of the above terms in the present application can be understood by those skilled in the art according to specific conditions.

In the Description of the present application, the description of the terms "an embodiment", "some embodiments", "specific embodiment" and the like indicates that the specific features, structures, materials or characteristics described in conjunction with the embodiment or example are included in at least one embodiment or example of the present application. In the Description, the illustrative description of the above terms does not necessarily refer to the same embodiment or example. Furthermore, the described specific features, structures, materials or characteristics may be combined in any suitable manner in any one or more embodiments or examples.

It should be understood by those skilled in the art that the above-mentioned implementation disclosed by the embodiments of the present application is the implementation employed merely for facilitating the understanding of the embodiments of the present application, and is not intended to limit the embodiments of the present application. Without departing from the spirit and scope of the embodiments of the present application, those skilled in the technical field of the embodiments of the present application may make various modifications and changes to the forms and details of the implementation, but the protection scope of the embodiments of the present application should be considered to be the protection scope defined by the appended Claims.

### Reference numerals in the Drawings:

1 - cable head housing, 11 - probe hole, 2 - first connector, 21 - spring, 22 - board connector, 3 - second connector, 31 - protrusion, 32 - subsequent circuit, 4 - probe.

## Claims

1. An RF cable head, comprising a cable head housing, and a first connector and a second connector, wherein both of the first connector and the second connector are disposed inside the cable head housing, the first connector is connected with the second connector; and
the cable head housing is provided with a probe hole through which a probe is inserted to disconnect the first connector from the second connector.

2. The RF cable head of claim 1, wherein
the first connector is provided with a spring connected with the second connector.

3. The RF cable head of claim 2, wherein
the probe hole faces the spring directly.

4. The RF cable head of any of claims 1 to 3, wherein
an end of the first connector away from the second connector is provided with a pin or a jack, which is configured to be matched and connected with a jack or a pin of a board connector.

5. The RF cable head of any of claims 1 to 3, wherein
an end of the second connector away from the first connector is provided with a pin or a jack, which is configured to be matched and connected with a jack or a pin of a subsequent circuit.

6. The RF cable head of claim 2 or 3, wherein
the spring is connected to the second connector through a protrusion.

7. The RF cable head of claim 6, wherein
the protrusion is disposed on the second connector or the spring.

8. The RF cable head of any of claims 1 to 3, wherein
the cable head housing is an insulating housing.

9. An RF performance testing device, comprising the RF cable head of any of claims 1 to 8.

10. The RF performance testing device of claim 9, further comprising a probe which is inserted through the probe hole to disconnect the first connector from the second connector during a test process.
